# EUROPÄISCHE PATENTSCHRIFT

(11) **EP 0 339 312 B1**
(45) Veröffentlichungstag und Bekanntmachung des Hinweises auf die Patenterteilung: **24.02.1993**
(21) Anmeldenummer: 89105937.0
(22) Anmeldetag: 05.04.1989
(51) Int. Cl.: H03K 4/06, H04N 3/233

(54) **Verfahren zur Erzeugung einer Spannung mit dreieckartigen Kurvenverlauf**
Process for the production of a triangular-like voltage
Procédé pour la production d'une tension de forme quasi-triangulaire

(30) Priorität: 29.04.1988 DE 3814561
(43) Veröffentlichungstag der Anmeldung: 02.11.1989
(73) Patentinhaber: Deutsche Thomson-Brandt GmbH, 78003 Villingen-Schwenningen (DE)
(72) Erfinder: Hartmann, Uwe, D-8391 Untergriesbach (DE); Ohnemus, Fritz, D-7730 Villingen-Schwenningen (DE)

(56) Entgegenhaltungen:
- EP-A- 0 276 449
- FR-A- 2 503 487
- IBM TECHNICAL DISCLOSURE BULLETIN, Band 13, Nr. 6, November 1970, Seiten 1405-1406, New York, US; L.E. AMBRICO: "CRT distortion correction circuit"

## Beschreibung

Die Erfindung betrifft ein Verfahren zur Erzeugung einer Spannung mit dreieckartigem Kurvenverlauf durch Addition einer sägezahnförmigen ersten Spannung zu einer sägezahnartigen Spannung, wobei die sägezahnartige Spannung durch Unterdrükken eines zur Mittellinie symmetrischen Teils einer zur ersten sägezahnförmigen Spannung gegenphasigen zweiten sägezahnförmigen Spannung derart umgeformt wird, daß sie im Zeitabschnitt 0,25T bis 0,75T waagerechte Abschnitte der Amplitude Null besitzt. Ein derartiges Verfahren wird in der älteren Patentanmeldung EP 0 276 449 A1, welche ein Dokument nach Art. 54(3) EPÜ darstellt, beschrieben, um eine dreieckförmige Spannung zu erzeugen, die zur Bildung eines Korrekturstromes dient, der in den Vertikalablenkstromkreis eines Fernsehempfängers eingekoppelt wird, um einen unter der Bezeichnung "gullwing" (Mövenflügel) bekannten Geometriefehler zu beseitigen, der sich insbesondere bei Bildröhren mit flachem Bildschirm unangenehm bemerkbar macht. Für diese bestimmten Bildröhren sind Korrekturschaltungen notwendig, die eine phasengetreue Grundwelle zur Frequenz des Ablenkstromes erzeugen müssen. Bekannt sind z.B. die Verwendung von Filterschaltungen oder auch von synchronisierten Oszillatorschaltungen, wobei jedoch eine Abstimmung auf die Grundwelle erfolgen muß, wozu zusätzlicher Schaltungsaufwand mit den entsprechenden Kosten notwendig ist. Insbesondere, wenn die Schaltung für mehrere vertikale Ablenkfrequenzen wahlweise geeignet sein soll, müssen diese Korrekturschaltungen auf die entsprechende Ablenkfrequenz abgeglichen werden. Die Verwendung unterschiedlicher Ablenkfrequenzen ist sehr aktuell zwecks höherer Bildauflösung und zwecks Vermeidung von störenden Flackererscheinungen auf dem Bildschirm.

Zukünftige Fernsehempfänger werden in der Lage sein, Ablenkfrequenzen mit 50, 60, 100 oder auch 120 Hz zu verarbeiten.

In der genannten Patentanmeldung wird zur Erzeugung des benötigten Kurvenverlaufs ein Verfahren beschrieben, bei welchem zwei Spannungen mit bestimmten Kurvenverläufen und gleicher Amplitude addiert werden. Messungen haben ergeben, daß der Gullwingfehler vom oberen Bildrand zum unteren Bildrand sinusförmigen Verlauf hat. Dabei geht dieser Gullwingfehler in der Nähe des oberen Bildrandes, in der Mitte und in der Nähe des unteren Bildrandes durch Null. Der Fehler ist z.B. während der ersten Zeilen des Bildhinlaufs positiv, geht dann sinusförmig über den Wert Null, erreicht in der oberen Bildhälfte des Bildhinlaufs einen negativen Höchstwert, geht dann in Bildmitte wiederum über den Wert Null, erreicht in der unteren Bildhälfte ein positives Maximum und geht über den Wert Null einige Zeilen vor Ende des Bildhinlaufs über den Wert Null wieder in negativer Richtung. Es zeigt sich demnach, daß die dreieckförmige gemäß Patentanmeldung EP 0 276 449 A1 erzeugte Spannung am oberen und unteren Bildrand noch modifiziert werden muß, damit die "invertierten" Fehlerabweichungen auch noch kompensiert werden.

Der Erfindung liegt die Aufgabe zugrunde, eine Lösung anzugeben, um diese Modifizierung zu ermöglichen. Diese Aufgabe wird durch die im Patentanspruch angegebene Maßnahme gelöst. Eine weitere Ausgestaltung der Erfindung ergibt sich aus dem Unteranspruch.

Die Erfindung wird nachstehend mit Hilfe der Zeichnung beschrieben.
- Figur 1: zeigt eine Schaltungsanordnung der Erfindung
- Figur 2: zeigt Diagramme zur Erläuterung der Wirkungsweise der Erfindung.

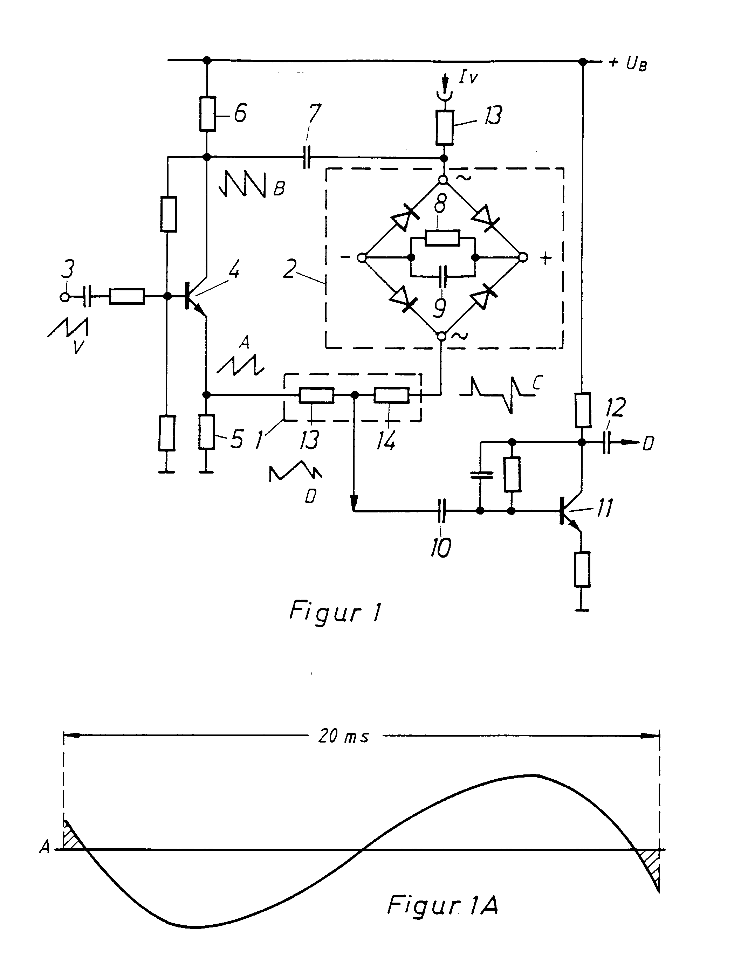

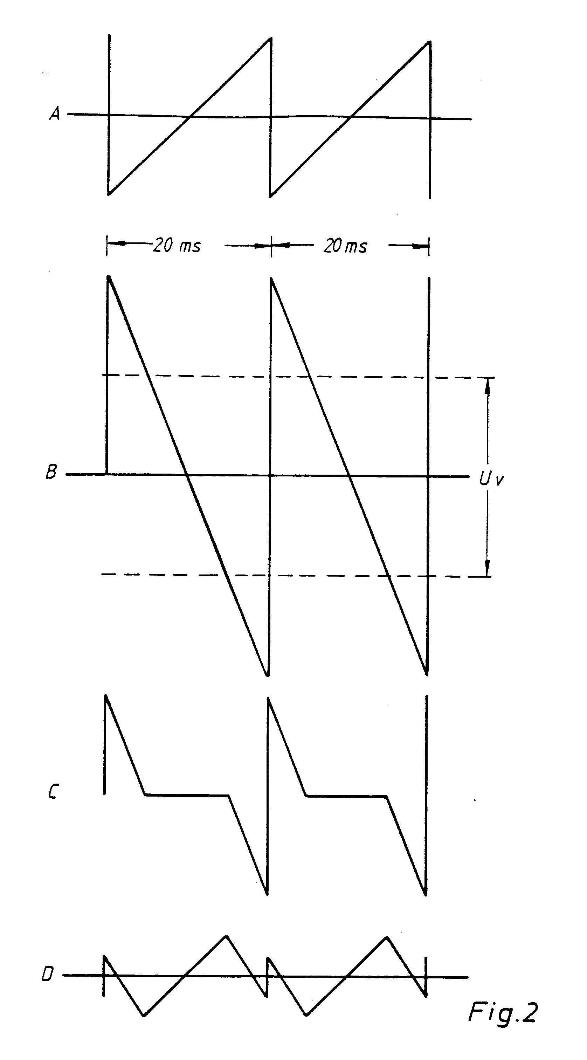

In Figur 1 wird zunächst nochmals die in der Patentanmeldung EP 0 276 449 A1 gezeigte Schaltung in ihrer Wirkungsweise erläutert, die den weiter oben beschriebenen Gullwingfehler gemäß Figur 1A beseitigt. Die Maßnahme der Erfindung kommt in Figur 2 zum Ausdruck.

In Figur 1 wird dem Eingang 3 einer Verstärkerstufe 4, das vertikalfrequente, sägezahnförmige Signal V zugeführt. Das dem Signal V gleichphasige Signal A nach Figur 2A wird am Emitterwiderstand 5 der Verstärkerstufe 4 abgenommen und der Additionsschaltung 1 zugeführt. Am Kollektorwiderstand 6 der Verstärkerstufe 4 wird das dem Signal V gegenphasige Signal B nach Figur 2B abgenommen und über den Kondensator 7 einer Diodenbrücke 2 zugeführt. Durch die Signalspitzen der Spannung B entsteht an dem RC-Glied 8, 9 eine Vorspannung für die Diodenbrücke 2. Am Ausgang der Diodenbrücke 2 entsteht die Signalspannung C nach Figur 2C mit dem durch die Vorspannung bewirkten waagrechten Teilen. Das Signal C wird dem anderen Eingang der Additionsschaltung 1 zugeführt. Wird nun gemäß der Maßnahme des Patentanspruchs die Amplitude der der Additionsschaltung zugeführten Spannungen nicht gleich groß gemacht, sondern in der Weise unterschiedlich, daß die Signalspannung C größer ist als die Signalspannung A, so ergibt sich am Ausgang der Additionsschaltung ein Kurvenverlauf nach Figur 2D. Man erkennt am Anfang und am Ende der Vertikalperiode jeweils einen invertierten Bereich, so daß mit Hilfe einer derartigen Korrektur der gewünschte Effekt eintritt. Die unterschiedlichen Amplituden der zu summierenden Spannungen können entweder dadurch erreicht werden, daß bereits an die Eingänge der Additionsschaltung 1 unterschiedlich große Spannungen gelegt werden oder aber dadurch, daß die Summierwiderstände 13, 14 unterschiedlich dimensioniert werden. Das so erzeugte Signal D gelangt über einen Koppelkondensator 10 an eine Verstärkerstufe 11 und wird über den Kondensator 12 ausgekoppelt.

## Patentansprüche

1. Verfahren zur Erzeugung einer Spannung mit dreieckartigem Kurvenverlauf durch Addition einer sägezahnförmigen ersten Spannung (A) zu einer sägezahnartigen Spannung (C), wobei die sägezahnartige Spannung (C) durch Unterdrücken eines zur Mittellinie symmetrischen Teils (UV) einer zur ersten sägezahnförmigen Spanung (A) gegenphasigen zweiten sägezahnförmigen Spannung (B) derart umgeformt wird, daß sie im Zeitabschnitt 0,25T bis 0,75T waagerechte Abschnitte der Amplitude Null besitzt, wobei die Amplitude der sägezahnartigen Spannung (C) größer ist als die Amplitude der sägezahnförmigen ersten Spannung (A) und die Addition der sägezahnförmigen ersten Spannung (A) zu der gegenphasigen mit den waagerechten Abschnitten versehenen Spannung (C) derart erfolgt, daß der dreieckartige Kurvenverlauf (D) Nulldurchgänge bei 0+dT, 0,5T und T-dT der Periode T besitzt.

2. Verfahren nach Anspruch 1, **dadurch gekennzeichnet,** daß die der Additionsschaltung (1) zugeführten zu summierenden Spannungen (A, C) gleich große Amplituden besitzen, und daß in der Additionsschaltung (1) die sägezahnartige Spannung (C) gegenüber der ersten sägezahnförmigen Spannung (A) mit einem Faktor größer 1 gewichtet wird.

## Claims

1. Method for the generation of a voltage having a triangular type of waveform by addition of a saw-tooth shaped first voltage (A) to a saw-tooth type of voltage (C), wherein the saw-tooth type of voltage (C) is transformed, by suppression of a portion (UV), symmetrical relative to the centre line, of a second saw-tooth shaped voltage (B) which is of opposite phase to the first saw-tooth shaped voltage (A), in such a way that it has horizontal sections of zero amplitude in the time interval 0.25T to 0.75T, wherein the amplitude of the saw-tooth type of voltage (C) is greater than the amplitude of the saw-tooth shaped first voltage (A) and the addition of the saw-tooth shaped first voltage (A) to the phase-opposed voltage (C) provided with the horizontal sections is effected in such a way that the triangular type of waveform (D) has zero crossings at 0+dT, 0.5T and T-dT of the period T.

2. Method in accordance with claim 1, characterised in that, the voltages (A, C) to be added, which are supplied to the summing circuit (1), have equally great amplitudes and that the saw-tooth type of voltage (C) is weighted in the summing circuit (1) by a factor greater than 1 relative to the first saw-tooth shaped voltage (A).

## Revendications

1. Procédé pour produire une tension avec une allure de courbe de type en triangle par addition d'une première tension en dent de scie (A) et d'une tension de type dent de scie (C), la tension de type dent de scie (C) étant transformée par suppression d'une partie symétrique (UV) à la ligne médiane d'une seconde tension en dent de scie (B) de phase opposée à la première tension en dent de scie (A) de telle manière qu'elle possède des portions horizontales d'amplitude zéro dans la période 0,25T à 0,75T, l'amplitude de la tension de type en dent de scie (C) étant supérieure à l'amplitude de la première tension en dent de scie (A) et l'addition de la première tension en dent de scie (A) et de la tension (C) de tension opposée, pourvue des portions horizontales, étant effectuée de manière telle que l'allure de courbe de type en triangle (D) possède des passages par zéro à 0+dT, 0,5T et T-dT de la période T.

2. Procédé selon la revendication 1, **caractérisé en ce** que les tensions (A, C) à additionner amenées au circuit d'addition (1) possèdent des amplitudes de même valeur et que dans le circuit d'addition (1) la tension de type en dent de scie (C) est pondérée par rapport à la première tension en dent de scie (A) avec un facteur supérieur à 1.
